## Europäisches Patentamt
## European Patent Office
## Office européen des brevets

(19)

(11) Numéro de publication: **0 143 686**
**B1**

(12) **FASCICULE DE BREVET EUROPEEN**

(45) Date de publication du fascicule du brevet:
22.06.88

(51) Int. Cl.⁴: **H 03 H 3/02**

(21) Numéro de dépôt: **84402133.7**

(22) Date de dépôt: **23.10.84**

(54) Procédé et dispositif d'usinage d'une lame de résonateur et lame ainsi obtenue.

(30) Priorité: **28.10.83 FR 8317320**

(43) Date de publication de la demande:
**05.06.85 Bulletin 85/23**

(45) Mention de la délivrance du brevet:
**22.06.88 Bulletin 88/25**

(84) Etats contractants désignés:
**BE CH DE GB LI NL**

(56) Documents cités:
**FR - A - 2 319 242**
**FR - A - 2 484 734**

**TOUTE L'ELECTRONIQUE, no. 468, novembre 1981, pages 48-51, Paris, FR; G. SILLIOC: "Filtres piézo-électriques de la centaine à la dizaine de microns"**
**PATENTS ABSTRACTS OF JAPAN, vol. 2, no. 120, 6 octobre 1978, page 6978E78**
**PROCEEDINGS OF THE 29TH ANNUAL FREQUENCY CONTROL SYMPOSIUM, US Army Electrical Command, 1975, Fort Monmouth, N.J., US; R.N. CASTELLANO et al.: "A survey of ion beam milling techniques for piezoelectric device fabrication", pages 128-134**

(73) Titulaire: **COMPAGNIE D'ELECTRONIQUE ET DE PIEZO-ELECTRICITE - C.E.P.E., 44, rue de la Glacière, F-95100 Argenteuil (FR)**

(72) Inventeur: **Vacheret, Xavier, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 19, avenue de Messine, F-75008 Paris (FR)**

## Description

La présente invention a pour objet un procédé et un dispositif d'usinage d'une lame de résonateur et plus particulièrement d'une région amincie de la lame, ainsi qu'une lame ainsi obtenue.

On connait du brevet US-A-3 694 677 un résonateur piézo-électrique comprenant un disque de quartz présentant en son centre une région amincie formant une membrane, cette région amincie étant raccordée à la région non amincie par une zone formant gradin. Une première électrode s'étend sur une face du disque depuis l'extérieur du disque jusqu'au centre de la région amincie, en franchissant la région formant gradin. Une deuxième électrode, disposée sur l'autre face du disque, s'étend depuis la périphérie du disque jusqu'au centre de la région amincie. Cette autre face du disque peut être plane ou bien présenter également une zone formant gradin, que doit alors franchir la deuxième électrode.

On connaît aussi de la demande de brevet japonais publiée sous le numéro 53-86187, un procédé de formation de motifs en relief sur une lame vibrante par usinage ionique des parties non recouvertes par un masque de photoresist.

Si on réalise les électrodes, par exemple en argent ou en aluminium, à l'aide du procédé enseigné par le brevet US-A-3 694 677, on constate qu'elles présentent un point de fragilité au niveau du gradin pouvant entrainer la mise hors d'usage du résonateur par interruption de la continuité électrique.

Dans la demande de brevet européenne EP-A-0 096 611 publiée le 21. décembre 1983 la Demanderesse a proposé de renforcer la première électrode par une patte conductrice déposée dans une zone formant gradin.

Cette couche conductrice, en général déposée par pulvérisation ou évaporation, a de préférence une épaisseur moyenne de 1000 A. Elle est de préférence en or. En pratique, elle est généralement plus large que l'électrode.

L'évolution actuelle de la technique conduit vers des résonateurs de fréquence de plus en plus élevée, ce qui impose de réduire de plus en plus l'épaisseur de la région non amincie.

Dans ces conditions, on est conduit à augmenter la hauteur du gradin, ce qui accroît les difficultés rencontrées au niveau de l'électrode qui doit le franchir. Le perfectionnement apporté par la patte de renforcement ne suffit pas toujours à assurer la fiabilité du contact électrique lorsque le gradin a une hauteur élevée (de l'ordre de 50 microns et plus).

La présente invention a pour objet de remédier à ces inconvénients. Dans ce but, elle a pour objet un procédé d'usinage et un dispositif correspondant permettant d'obtenir un gradin progressif facilitant la tenue mécanique de l'électrode qui franchit le gradin, celle-ci étant de préférence renforcée par une patte conductrice telle que décrite dans la demande de brevet EP-A-0 096 611 précitée.

L'invention concerne tout d'abord un procédé d'usinage d'une région amincie dans au moins une lame d'un résonateur par bombardement ionique, mettant en œuvre d'au moins un iris, caractérisé en ce que l'iris présente une région bordant son ouverture et profilée de telle sorte que, lors du bombardement, elle soit au moins partiellement consommée et provoque un élargissement de l'ouverture de l'iris, de manière à profiler le gradin existant entre la région amincie et le reste de la lame.

Selon une première variante, ladite région présente en coupe, la forme d'une marche.

Selon une deuxième variante, ladite région est tronconique.

Le procédé selon l'invention peut avantageusement comporter des étapes supplémentaires de dépôt d'une patte conductrice au niveau du gradin, et de dépôt de deux électrodes dont l'une recouvre au moins partiellement la patte conductrice.

L'invention concerne également un dispositif pour la mise en œuvre du procédé défini ci-dessus. Il comporte un dispositif de bombardement ionique projetant un faisceau·d'ions en direction d'au moins une lame d'un résonateur et au moins un iris disposé au regard de ladite lame de manière à masquer la périphérie de celle-ci et à laisser passer des ions du faisceau par une ouverture dudit iris. Il est caractérisé en ce que ledit iris présente une région bordant son ouverture et profilée de telle sorte que, lors du bombardement, elle soit au moins partiellement consommée et provoque un élargissement de l'ouverture dudit iris, de manière à profiler le gradin entre la région amincie et le reste de la lame.

Selon une première variante, ladite région présente, en coupe, la forme d'une marche.

Selon une deuxième variante, ladite région est tronconique.

L'invention concerne enfin une lame de résonateur résultant de la mise en œuvre du procédé selon l'invention. Elle est du type présentant une région périphérique non-amincie et une région centrale amincie, ainsi qu'un gradin reliant la région périphérique et la région centrale. Elle est caractérisé en ce que le gradin est progressif.

Selon une première variante, le gradin se présente sous la forme d'une double marche.

Selon une deuxième variante, le gradin se présente en section sous la forme d'une courbe monotone.

Selon un mode de réalisation préféré, elle présente une électrode associée à une patte conductrice constituée par une couche métallique déposée dans la zone formant gradin.

L'invention sera mieux comprise à la lecture de la description qui va suivre, donnée à titre d'exemple non limitatif, en liaison avec les dessins annexés qui représentent:

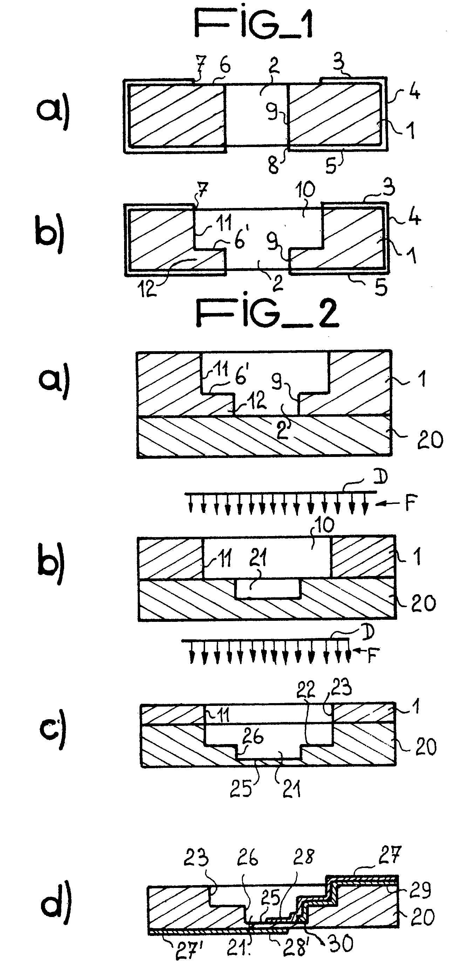

– les figures 1a et 1b, les étapes de fabrication d'un premier mode de réalisation d'un iris selon l'invention, destiné à être mis en œuvre dans un premier mode de mise en œuvre du procédé d'usi-

nage selon l'invention, dont les étapes sont illustrées aux figures 2a à 2d;

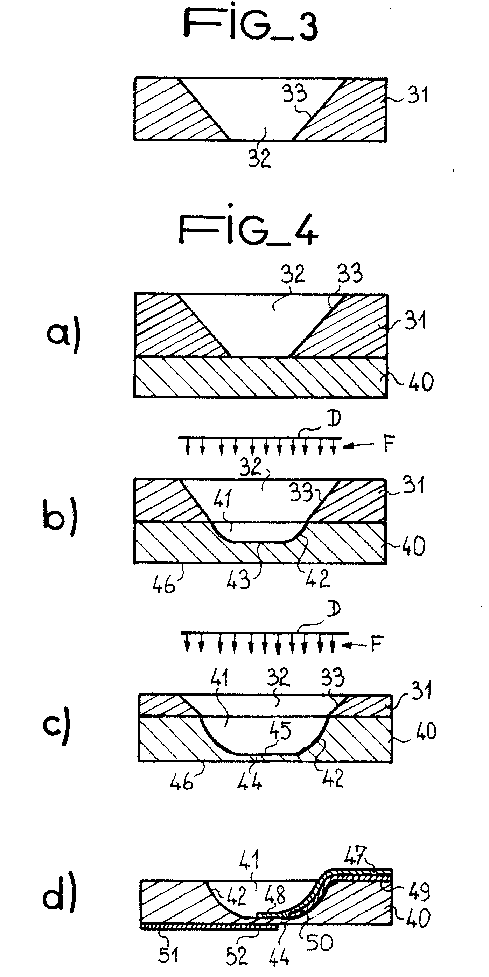

– la figure 3, un deuxième mode de réalisation d'un iris selon l'invention, destiné à être mis en œuvre dans un deuxième mode de mise en œuvre du procédé d'usinage selon l'invention, dont les étapes sont illustrées aux figures 4a à 4d.

Selon la figure 1b, un iris 1 présente une ouverture centrale 2 bordée par une région 12 formant une marche (9, 6'). Pour la réaliser, on part d'un disque percé en son centre d'une ouverture 2 et recouverte sur ses faces extérieures d'un vernis de masquage ou d'un dépôt métallique de masquage (3, 4, 5), à l'exception d'une région de préférence circulaire 6 bordant l'ouverture 2 sur l'une des faces du disque. On réalise une attaque chimique du disque, qui a pour effet de creuser celui-ci dans les régions 6 non masquées, de manière à former une portion d'ouverture 10 plus large que l'ouverture 2, et délimitée par un fond 6' et en rebord 11. Le bord 9 de la partie de l'ouverture 2 qui subsiste et le fond 6' délimitent ainsi la région 12.

Selon la figure 2a, l'iris 1, après élimination du vernis ou du dépôt métallique (3, 4, 5), est mis en contact avec une lame constituée par un disque 20 de matériau piézo-électrique, par exemple en quartz ou en tantalate de lithium, en vue de réaliser un usinage ionique. Celui-ci est effectué (figure 2b) sous vide par un dispositif de bombardement ionique D émettant un faisceau d'ions F perpendiculairement à la surface du résonateur. Plus particulièrement, la figure 2b fixe le moment où la région 12 a été entièrement consommée. Le disque 20 présente à ce moment en son centre une ouverture borgne 2, dont le diamètre correspond à celui de l'ouverture 2, et l'ouverture de l'iris 1, se limite à la seule partie subsistante de l'ouverture 10.

L'usinage se poursuit (figure 2c) jusqu'à ce que le fond de l'ouverture borgne 21 délimite une membrane 25 d'épaisseur désirée. A ce stade, l'épaisseur de l'iris 1 a encore diminué, et son ouverture se limite toujours à la partie subsistante de l'ouverture 10.

Le disque 20 présente alors un gradin formé d'une double marche. La première marche est constituée par la face supérieure du disque 20 et la paroi verticale usinée 23, et la deuxième par le fond plat usiné 22 et la paroi verticale 26.

Selon la figure 2d, on dépose ensuite une patte métallique 29 qui s'étend en franchissant la double marche du gradin depuis la face supérieure du disque 20 jusqu'à une extrémité 30 située à la périphérie de la membrane 25.

Une électrode 27 est ensuite déposée et elle s'étend en franchissant la double marche du gradin depuis la périphérie de la face supérieure du disque 20 jusqu'à une extrémité 28 située au centre de la membrane 25, en même temps qu'une deuxième électrode 27' depuis la périphérie de la face inférieure du disque 20 jusqu'à une extrémité 28' située au centre de la membrane 25 en vis-à-vis de l'extrémité 28 de l'électrode 27.

On comprendra qu'en général l'usinage est réalisé en soumettant une pluralité de lames à un même bombardement ionique, chaque lame étant équipée à cet effet d'un iris.

Selon la figure 3, un iris 31 présente une ouverture 32 dont le bord 33 est tronconique.

L'iris 31 est mis en contact par sa face où l'ouverture 32 a le plus petit diamètre (figure 4a) avec une lame constituée par un disque 40 en matériau piézo-électrique. L'ensemble est disposé dans une enceinte à vide comportant un dispositif de bombardement ionique D produisant un faisceau d'ions F perpendiculaire à la surface du disque. Lors de l'usinage, une ouverture borgne 41 aux rebords incurvés 42 et au fond plat 43 est creusée progressivement. Grâce à la forme tronconique du bord 33 de l'ouverture 32 de l'iris 31, le diamètre de l'iris 31 en contact avec le disque 40 s'élargit progressivement. C'est ce phénomène de consommation de l'iris 31 qui confère au rebord 43 un profil incurvé.

En fin d'usinage (figure 4c), on obtient un disque 40 pourvu d'un gradin incurvé 42 et d'une membrane 44 dont une face est la face inférieure du disque 40 et dont l'autre face est le fond plat 45 de l'ouverture 41.

Selon la figure 4d, on dépose une patte conductrice 49 s'étendant en traversant le gradin incurvé 42 depuis la face supérieure du disque 40 jusqu'à une extrémité 50 située à la périphérie de la membrane 44.

On dépose ensuite simultanément une première électrode 47 qui s'étend, en franchissant le gradin incurvé 42, depuis la périphérie de la face supérieure du disque 40 jusqu'à une extrémité 48 située au centre de la membrane 44, ainsi qu'une deuxième électrode 51 qui s'étend depuis la périphérie de la face inférieure du disque 40 jusqu'à une extrémité 52 située au centre de la membrane 44 en vis-à-vis de l'extrémité 48 de l'électrode 47.

Comme dit précédemment, on réalise en général simultanément l'usinage de plusieurs lames 5.

On remarquera que les exemples décrits ci-dessus ne sont donnés qu'à titre d'exemple non limitatif. Il n'est par exemple pas nécessaire que le faisceau d'ions soit orienté perpendiculairement à la surface du disque à usiner.

**Revendications**

1. Procédé d'usinage d'une région amincie d'une lame d'un résonateur par bombardement ionique mettant en œuvre un iris, caractérisé en ce que l'iris (1, 31) présente une région (12, 33) bordant son ouverture (2, 32) et profilée de telle sorte que lors du bombardement, elle soit au moins partiellement consommée et provoque un élargissement de l'ouverture (2, 32) de l'iris (1, 31), de manière à profiler un gradin (22, 23, 26, 42) existant entre la région amincie (25, 44) et le reste de la lame (20, 40).

2. Procédé selon la revendication 1, caractérisé en ce que ladite région présente en coupe la forme d'une marche (9, 6', 11).

3. Procédé selon la revendication 1, caractérisé en ce que ladite région est tronconique (32).

4. Procédé selon une des revendications précédentes, caractérisé en ce qu'il comporte des étapes supplémentaires de dépôt d'une patte conductrice (29, 49) au niveau du gradin et de dépôt de deux électrodes (27, 27', 47, 51) dont l'une recouvre au moins partiellement la patte conductrice (29, 49).

5. Dispositif pour la mise en œuvre du procédé selon une des revendications 1 à 4 et comportant un dispositif de bombardement ionique projetant un faisceau d'ions en direction d'au moins une lame d'un résonateur et au moins un iris disposé en regard de ladite lame de manière à masquer la périphérie de ladite lame de quartz et à laisser passer des ions du faisceau par une ouverture de l'iris, caractérisé en ce que ledit iris (1, 31) présente une région (12, 33) bordant son ouverture (2, 32) et profilée de telle sorte que, lors du bombardement, elle soit au moins partiellement consommée et provoque un élargissement de l'ouverture (2, 32) de l'iris (1, 31), de manière à profiler le gradin (22, 23, 26, 42) entre la région amincie (25, 44) et le reste de la lame (20, 40).

6. Dispositif selon la revendication 5, caractérisé en ce que ladite région présente, en coupe, la forme d'une marche (9, 6', 11).

7. Dispositif selon la revendication 5, caractérisé en ce que ladite région est tronconique (33).

8. Lame de résonateur présentant une région périphérique non amincie et une région centrale amincie ainsi qu'un gradin reliant la région périphérique et la région centrale, caractérisée en ce que le gradin (22, 25, 26, 42) est progressif.

9. Lame selon la revendication 8, caractérisée en ce que le gradin se présente sous la forme d'une double marche (22, 25, 26).

10. Lame selon la revendication 8, caractérisée en ce que le gradin se présente en section sous la forme d'une courbe monotone (42).

11. Lame selon les revendications 8 à 10, caractérisée en ce qu'elle présente une électrode (27, 47) associée à une patte conductrice (29, 49) constituée par une couche métallique déposée dans la zone formant gradin.

**Patentansprüche**

1. Verfahren zur Bearbeitung eines verdünnten Bereichs eines Plättchens eines Resonators durch Ionenbeschuss unter Verwendung einer Lochblende, dadurch gekennzeichnet, dass die Lochblende (1, 31) einen Randbereich (12, 33) um das Loch (2, 32) herum aufweist, der so gestaltet ist, dass während des Ionenbeschusses dieser Randbereich zumindest teilweise verbraucht wird und eine Vergrösserung des Lochs (2, 32) der Lochblende (1, 31) bewirkt, so dass sich ein Absatz (22, 23, 26, 42) zwischen dem verdünnten Bereich (25, 44) und dem übrigen Plättchen (20, 40) ergibt.

2. Verfahren nach Anspruch 1, dadurch gekennzeichnet, dass dieser Randbereich im Schnitt die Form einer Stufe (9, 6', 11) aufweist.

3. Verfahren nach Anspruch 1, dadurch gekennzeichnet, dass der Randbereich kegelstumpfförmig (32) ist.

4. Verfahren nach einem der vorhergehenden Ansprüche, dadurch gekennzeichnet, dass es zusätzliche Verfahrensschritte enthält, indem eine Leitfahne (29, 49) in Höhe der Stufe und zwei Elektroden (27, 27', 47, 51) aufgebracht werden, von denen eine zumindest teilweise die Leitfahne (29, 49) überdeckt.

5. Vorrichtung zur Durchführung des Verfahrens nach einem der Ansprüche 1 bis 4 unter Verwendung einer Ionenbeschussvorrichtung, die einen Ionenstrahl auf mindestens ein Resonatorplättchen richtet, und mindestens einer Lochblende, die vor dem Plättchen liegt und den Rand des Quarzplättchens abdeckt, während Ionen des Strahls durch das Loch der Blende hindurch dringen, dadurch gekennzeichnet, dass die Lochblende (1, 31) einen Randbereich (12, 33) um das Loch (2, 32) besitzt, der so gestaltet ist, dass er während des Ionenbeschusses mindestens teilweise verbraucht wird und eine Verbreiterung des Lochs (2, 32) der Lochblende (1, 31) bewirkt, so dass eine Stufe (22, 32, 26, 42) zwischen dem verdünnten Bereich (25, 44) und dem übrigen Plättchen (20, 40) entsteht.

6. Vorrichtung nach Anspruch 5, dadurch gekennzeichnet, dass der Randbereich im Schnitt Treppenstufenform (9, 6', 11) besitzt.

7. Vorrichtung nach Anspruch 5, dadurch gekennzeichnet, dass der Randbereich kegelstumpfförmig (33) ist.

8. Resonatorplättchen, das einen nicht verdünnten Randbereich und einen verdünnten Zentralbereich sowie eine Stufe im Übergang zwischen dem Randbereich und dem Zentralbereich aufweist, dadurch gekennzeichnet dass die Stufe (22, 25, 26, 42) progressiv ist.

9. Plättchen nach Anspruch 8, dadurch gekennzeichnet, dass die Stufe sich in Form einer doppelten Treppenstufe (22, 25, 26) darstellt.

10. Plättchen nach Anspruch 8, dadurch gekennzeichnet, dass die Stufe im Querschnitt eine stetige Kurve (4, 2) darstellt.

11. Plättchen nach den Ansprüchen 8 bis 10, dadurch gekennzeichnet, dass es eine einer Leitfahne (29, 49) zugeordnete Elektrode (27, 47) besitzt, wobei die Leitfahne als auf die die Stufe bildende Zone aufgebrachte Metallschicht ausgebildet ist.

**Claims**

1. A method for obtaining a thinner zone in a resonator blade by ion bombardment using an iris, characterized in that the iris (1, 31) presents an edge zone (12, 33) around its opening (2, 32) which is shaped such that during the bombardment, this edge zone is at least partially consumed and causes the opening (2, 32) of the iris (1, 31) to be enlarged such that a step (22, 23, 26, 42) is obtained between the thinner zone (25, 44) and the remaining blade (20, 40).

2. A method according to claim 1, characterized in that said edge zone presents a shape corresponding in cross-section to a stair (9, 6', 11).

3. A method according to claim 1, characterized in that said edge zone has a frustroconical shape (32).

4. A method according to one of the preceding claims, characterized in that it comprises additional method steps of depositing a conductive strip (29, 49) at the level of the step and of depositing two electrodes (27, 27', 47, 51), one of which is laid at least partially on the conductive strip (29, 49).

5. A device for implementing the method according to one of claims 1 to 4 and comprising a ion bombardment device projecting a ion beam towards at least one resonator blade, and at least one iris disposed opposite said plate such that the periphery of said quartz blade is masked and that ions in the beam may pass through an opening in the iris, characterized in that said iris (1, 31) presents an edge zone (12, 33) around its opening (2, 32) which is shaped such that during the bombardment, this edge zone is at least partially consumed and causes the opening (2, 32) of the iris (1, 31) to be enlarged such that a step (22, 23, 26, 42) is obtained between the thinner zone (25, 44) and the remaining blade (20, 40).

6. A device according to claim 5, characterized in that said edge zone presents a shape corresponding in cross-section to a stair (9, 6', 11).

7. A device according to claim 5, characterized in that said edge zone has a frustroconical shape (32).

8. A resonator blade having a peripheral zone and a thinner central zone as well as a step between the peripheral and the central zone, characterized in that the step (22, 25, 26, 42) is a progressive step.

9. A blade according to claim 8, characterized in that the step is constituted by a twin stair (22, 25, 26).

10. A blade according to claim 8, characterized in that the step is shaped as to present in cross-section a steady curve (42).

11. A blade according to claims 8 to 10, characterized in that it presents an electrode (27, 47) associated to a conductive strip (29, 49) constituted by a metal layer which is deposited in the zone of the step.

FIG_1

FIG_2

# FIG_3

# FIG_4

a)

b)

c)

d)